**Europäisches Patentamt**

**European Patent Office**

**Office européen des brevets**

(19)

(11) Veröffentlichungsnummer: **0 200 913 B1**

# (12) EUROPÄISCHE PATENTSCHRIFT

(45) Veröffentlichungstag der Patentschrift:
12.12.90

(21) Anmeldenummer: **86104344.6**

(22) Anmeldetag: **29.03.86**

(51) Int. Cl.⁵: **G03F 7/32**

(54) Entwicklergemisch, dessen Verwendung und ein Verfahren zur Herstellung von Flachdruckplatten mit diesem Entwickler.

(30) Priorität: **11.04.85 US 721981**

(43) Veröffentlichungstag der Anmeldung:
**17.12.86 Patentblatt 86/46**

(45) Bekanntmachung des Hinweises auf die Patenterteilung:
**12.12.90 Patentblatt 90/50**

(84) Benannte Vertragsstaaten:
**DE FR GB NL**

(56) Entgegenhaltungen:
**EP-A- 0 027 932**
**DE-A- 2 364 631**

(73) Patentinhaber: **HOECHST CELANESE CORPORATION, Route 202-206 North, Somerville, N.J. 08876(US)**

(72) Erfinder: **Hsieh, Shane, 4, Linvale Lane, Bridgewater New Jersey 08807(US)**
Erfinder: **Mitchell, Wayne A., 8, Shydy Lane, Bound Brook New Jersey 08805(US)**

(74) Vertreter: **Euler, Kurt Emil, Dr., HOECHST AG - Werk KALLE Patentabteilung Postfach 3540 Rheingaustrasse 190, D-6200 Wiesbaden(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft ein Entwicklergemisch zum Entfernen der Nichtbildstellen von belichteten negativ arbeitenden Flachdruckplatten, die aus einem mit einer lichtempfindlichen Schicht versehenen Schichtträger bestehen, die Verwendung des Gemisches und ein Verfahren zur Herstellung von Flachdruckplatten mit diesem Entwickler.

Es wurden in der Vergangenheit verschiedene Verfahren zum Entwickeln von Druckplatten eingesetzt, wie z. B. die Verwendung von Gemischen, die aus Lösungen von organischen Lösemitteln, Netzmitteln, Salzen, Säuren und anderen aus dem Stand der Technik bekannten Stoffen bestehen.

Es wird angestrebt, ein Entwicklergemisch herzustellen, mit dem die Entwicklung innerhalb kurzer Zeit erfolgen kann. Die oleophilen Bildstellen der Druckplatte sollten dabei farbannehmend und wasserabweisend sein, während die hydrophilen Nichtbildstellen Wasser annehmen und fette Druckfarbe abstoßen sollten.

Die richtige Auswahl der für die Entwicklerlösung jeweils verwendeten Lösemittel ist von großer Bedeutung. Wenn das eingesetzte Lösemittel für das lichtempfindliche Gemisch selbst gut geeignet ist, findet keine genügende Unterscheidung zwischen den belichteten und den unbelichteten Stellen statt. Infolgedessen wird ein Großteil der Schichtbestandteile der Bildstellen im Lösemittel gelöst oder quillt stark an und löst sich ab. Solche Druckplatten sind unbrauchbar. Durch die Zugabe von Wasser zur Senkung der Lösemittelkonzentration in der Entwicklerlösung kann die Bilddifferenzierung verbessert werden. Während der Entwicklung von Druckplatten, insbesondere von negativ arbeitenden Druckplatten, werden jedoch die an den Nichtbildstellen vorhandenen harzartigen Bindemittel, wie Acetale, insbesondere Polyvinylformal, in der Entwicklerlösung solvatisiert und lösen sich vom Schichtträger ab und ballen sich zu kugeligen, sehr klebrigen Gebilden zusammen. Derartig solvatisierte Partikel lagern sich auf den noch lösemittelfeuchten Bildstellen ab und bleiben dort auch nach dem Trocknen haften. Diese "wiederangelagerten" Stellen sind mit bloßem Auge auf der entwickelten Druckplatte erkennbar und werden überdies von der klebrigen Druckfarbe beim Druckvorgang zusammen mit der eigentlichen, darunterliegenden Bildstelle von der Platte abgerissen, wodurch Löcher entstehen, die auf dem fertigen Druck als bildfreie Stellen erkennbar sind.

Um diesem Problem wenigstens teilweise abzuhelfen, werden in vielen bekannten Entwicklergemischen flüchtige Lösemittel verwendet. Von der Anwesenheit solch flüchtiger Lösemittel der Entwicklerlösung wird erhofft, daß durch eine rasche Verdampfung des Lösemittels das Klebrigwerden der Bildstellen verhindert wird. Die Verwendung großer Mengen wasserlöslicher Lösemittel mit niedrigem Siedepunkt, die z.B. im Entwickler gemäß der US-A 3 954 472 vorgeschlagen wurden, führt jedoch zu Problemen im Hinblick auf eine Gesundheitsgefährdung am Arbeitsplatz, Sicherheitsrisiken aufgrund des niedrigen Flammpunktes und zur Umweltbelastung. Durch eine Senkung der Konzentration dieser wasserlöslichen Lösemittel mit niedrigem Siedepunkt können diese Probleme zwar auf ein Minimum reduziert werden, doch verlängert sich gleichzeitig die Entwicklungszeit. Die Klebrigkeit der Schichten wird zwar verringert, kann aber nicht völlig ausgeschaltet werden.

Um die für die Entwicklung benötigte Zeit bei der Verwendung von Entwicklerlösungen mit einem geringeren Gehalt an Lösemitteln mit niedrigem Siedepunkt abzukürzen, wird in einigen Fällen zusätzlich ein organisches Lösemittel eingesetzt. Derartige Entwickler weisen jedoch leider etliche Nachteile auf, wie z. B. Toxizität, geringere Entwicklerstabilität, Geruchsbelästigung oder Unvermögen, den Bildhintergrund an den Nichtbildstellen vollständig freizulegen.

Flachdruckplatten bestehen im allgemeinen aus einem Schichtträger auf Aluminiumbasis, der gegebenenfalls mit Hilfe eines der vielen bekannten Verfahren zusätzlich behandelt wurde, z.B. durch anodische Oxidation, mechanische Aufrauhverfahren oder Hydrophilierung. Auf den solchermaßen vorbereiteten Schichtträger wird eine lichtempfindliche Schicht aus Photosensibilisator, harzartigen Bindemitteln, Farbmitteln, stabilisierenden Säure, Netzmitteln und anderen bekannten Bestandteilen aufgetragen. Zu den üblicherweise verwendeten Photosensibilisatoren zählen Diazoniumverbindungen, wie polymere Diazoniumsalzkondensationsprodukte und photopolymerisierbare Gemische. Sensibilisatoren, Bindemittel und Druckplatten, für deren Herstellung aromatische Diazoniumverbindungen verwendet werden, sind beispielsweise aus den US-A 3 175 906, 3 046 118, 2 063 631, 2 667 415, 3 867 147 und 3 679 419 bekannt.

Typische, zum Stand der Technik zählende Entwicklergemische sind in den US-A 2 754 279 und 4 381 340 sowie in der DE-A 22 16 419 beschrieben.

In der EP-A 0 027 932 wird ein Entwicklergemisch zum Entwickeln von belichteten lichtempfindlichen Kopierschichten beschrieben, enthaltend neben wasserlöslichen Alkali- und Erdalkaliphosphaten, Netzmitteln wie Natriumfettalkoholpolyglykolethersulfat und Alkoholen wie Benzylakohol ein wasserlösliches oder in Wasser zu stabilen Dispersionen dispergierbares Mischpolymerisat eines N-Vynilamins, eines Vinylalkohols oder eines Vinylalkoholderivates.

Mit Hilfe der vorliegenden Erfindung sollen die erwähnten Nachteile bekannter Entwickler für Flachdruckplatten überwunden werden.

Aufgabe der vorliegenden Erfindung ist es daher, einen Entwickler für Flachdruckplatten zu schaffen, mit dessen Hilfe die Herstellung von Druckplatten möglich wird, die im wesentlichen frei sind von unerwünschten Wiederanlagerungen, die eine geringere Toxizität aufweisen und weniger Geruchsbelästigungen verursachen und ferner einen höheren Flammpunkt besitzen, wobei unter dem Aspekt der Wirtschaftlichkeit betrachtet gleichzeitig eine ausreichende Entfernung der Nichtbildstellen erreicht wird.

Die Aufgabe wird gelöst durch einen Entwickler, der im wesentlichen aus einem Gemisch aus

a) 4,5 bis 27 Gew.% α-Hydroxytoluol,
b) 0,1 bis 30 Gew.% eines $C_{12}$-Natriumalkylethersulfats,
c) 0,1 bis 10 Gew.% wenigstens eines Salzes aus der Gruppe der Alkaliphosphate, -nitrate, -chloride, -borate, -acetate, -sulfate, -citrate, -sulfite, -tartrate, -oxalate, -formiate, -propionate, -succinate, -glutamate oder -benzoate und
d) 0,1 bis 10 Gew.% wenigstens einer Verbindung aus der Gruppe Polymethoxyethylenglykol, Polyethylenglykol, Propylenglykol oder Glycerin

besteht, wobei das Gewichtsverhältnis von a) zu b) (bezogen auf den Feststoff) zwischen 0,9:1 und 1,5:1 liegt, der Dampfdruck des Entwicklers 0,15 mm Quecksilbersäule bei 25°C nicht übersteigt und sein Flammpunkt mindestens bei 200°F (93 °C) liegt.

Die Erfindung betrifft auch ein Verfahren zur Herstellung eines Reliefbildes, bei dem ein lichtempfindliches Material aus einem Schichtträger mit einem darauf aufgebrachten negativ arbeitenden lichtempfindlichen Gemisch bildmäßig belichtet wird und die unbelichteten Nichtbildstellen anschließend mit dem oben genannten wäßrigen Entwickler entfernt werden, wobei es mit dessen Hilfe möglich ist, die Nichtbildstellen innerhalb von höchstens 2 min praktisch vollständig zu entfernen, ohne daß dabei merkliche Teile der belichteten Bildstellen mitentfernt werden oder Substanz von den entfernten Nichtbildstellen auf dem lichtempfindlichen Material wieder angelagert wird.

Bei der Herstellung negativ arbeitender lichtempfindlicher Materialien, wie z.B. Flachdruckplatten, wird zunächst ein blattförmiger Träger, der beispielsweise aus zur Herstellung von Flachdruckplatten geeigneten Aluminiumlegierungen wie Alcoa 3003 und Alcoa 1100 besteht und gegebenenfalls auf übliche Weise, z.B. durch mechanisches Aufrauhen und/oder Ätzen und/oder anodische Oxidation vorbehandelt wurde und gegebenenfalls außerdem mit einem Gemisch, wie z.B. Polyvinylphosphonsäure, behandelt wurde, das als Hydrophilierungsmittel für Flachdruckplatten geeignet ist, mit einem strahlungsempfindlichen, ein polymeres Diazoniumsalz oder ein Photopolymeres enthaltenden Gemisch beschichtet. Dieses Gemisch kann außerdem harzförmige Bindemittel wie Polyvinylformalharze, Farbmittel, stabilisierende Säuren, Netzmittel, Belichtungsindikatoren oder andere bekannte Zusätze enthalten.

Anschließend wird das lichtempfindliche blattförmige Material mittels einer Strahlungsquelle unter Zuhilfenahme einer Maske oder Transparentvorlage belichtet und die belichtete Platte zur Entfernung nichtbelichteter lichtempfindlicher Teile entwickelt.

Das lichtempfindliche Gemisch wird gewöhnlich als Gemisch in einem oder mehreren Lösemittel(n) hergestellt, in dem (denen) alle Bestandteile untereinander verträglich sein müssen. Der Schichtträger wird mit diesem lichtempfindlichen Gemisch beschichtet, und das Lösemittel wird verdampft.

Die Diazoniumverbindungen, die im Rahmen dieser Erfindung für die Herstellung lichtempfindlicher Gemische am häufigsten verwendet werden, entsprechen der allgemeinen Formel A-$N_2^+$X$^-$, in der A ein aromatischer oder heterozyklischer Rest und X das Anion einer Säure ist.

Zu den für die vorstehend genannten Zwecke geeigneten lichtempfindlichen Diazoniummaterialien gehören insbesondere höhermolekulare Gemische, die z. B. durch die Kondensation bestimmter aromatischer Diazoniumsalze in einem sauren Medium mit bestimmten aromatischen Carbonylverbindungen wie Formaldehyd erhalten werden, wie es beispielsweise in den US-A 2 063 631 und 2 667 415 beschrieben ist. Die Gruppe der Diazoniumverbindungen, die bevorzugt eingesetzt wird, ist in der US-A 3 849 392 beschrieben. Besonders bevorzugt wird unter den Diazoniumsalzen das aus der US-A 3 849 392 bekannte, als Mesitylensulfonat ausgefällte Polykondensationsprodukt aus 3-Methoxy-4-diazodiphenylaminsulfat und 4,4'-Bismethoxymethyldiphenylether.

Geeignete photopolymerisierbare Gemische sind dem Fachmann bekannt.

Die vorliegende Erfindung sieht einen Entwickler und ein Verfahren zum Entwickeln solcher belichteter, lichtempfindlicher Materalen vor, bein denen zum Entfernen der unbelichteten Nichtbildstellen ein Entwickler verwendet wird, der die erwähnten Bestandteile in wäßriger Lösung enthält. Der erfindungsgemäß erhaltene Entwickler hat einen Flammpunkt von mindestens 200°F (93°C), bevorzugt von mindestens 220°F (104°C). Sein Dampfdruck beträgt höchstens 15 mm Quecksilbersäule bei 25°C.

Die α-Hydroxytoluolkomponente ist im Entwicklergemisch in einer Menge von 4,5 bis 27 Gew.%, bevorzugt von 4,6 bis 10 Gew.% und insbesondere von 5 bis 6 Gew.%, jeweils bezogen auf das Gewicht des Entwicklers, vorhanden.

Das Gemisch enthält mindestens ein Salz aus der Gruppe der Kalium- und Natriumphosphate, -nitrate,- chloride, -borate, -acetate, -sulfate, -citrate, -sulfite, -tartrate, -oxalate, -formiate, -propionate, -succinate, -glutamate und -benzoate. Die Salzkomponente ist im Entwickler in einer Menge von 0,1 bis 10 Gew.% bevorzugt von 0,5 bis 10 Gew.% und insbesondere von 1 bis 5 Gew.%, jeweils bezogen auf das Gewicht des Entwicklers, vorhanden.

Das Gemisch enthält mindestens eine Komponente aus der Gruppe Polymethoxyethylenglykol, Polyethylenglykol, Propylenglykol und Glycerin. Diese Komponente ist im Entwickler in einer Menge von 0,1 bis 10 Gew.-%, bevorzugt von 0,5 bis 7 Gew.-% und insbesondere von 1 bis 5 Gew.-%, jeweils bezogen auf das Gewicht des Entwicklers, vorhanden.

Das Gemisch enthält ferner ein $C_{12}$-Natriumalkylethersulfat. Diese Komponente ist im Entwickler in einer Menge von 0,1 bis 30 Gew.-%, bevorzugt von 1 bis 20 Gew.-% und insbesondere von 2 bis 10 Gew.-%, jeweils bezogen auf das Gewicht des Entwicklers, vorhanden. Eine besonders bevorzugte Verbindung dieser Klasse ist Abex[(R)] 18-S, Hersteller: Alcolac, Baltimore, Maryland, USA. Das Gewichtsverhältnis von α-Hydroxytoluol zu $C_{12}$-Natriumalkylethersulfat liegt bevorzugt zwischen 0,9:1 und 1,5:1.

In bevorzugter Ausführungsform enthält der erfindungsgemäße Entwickler noch geringere Mengen anderer Bestandteile, die die Verarbeitung der Druckplatte erleichtern und zur Verhinderung von Tonerscheinungen auf den Nichtbildstellen des Reproduktionsmaterials beitragen und außerdem die Hydrophilie der Bildhintergrundstellen in den Fällen erhöhen, wo das Material in Form einer Flachdruckplatte vorliegt. Solche Bestandteile sind z.B. Mittel zur Verhinderung von Schaumbildung und Oxidation, Filmbildner wie Polyethylenglykol, Polyvinylpyrrolidon und Stärke, durch die die Neigung entfernter Schichtteile zur Wiederanlagerung auf der Plattenoberfläche verringert wird, und die für eine Konservierung der Platte durch den Entwickler sorgen.

Ein bevorzugtes Mittel zur Verhinderung von Schaumbildung ist Dow[(R)] DB-31. Ein bevorzugtes Antioxidans ist Irganox[(R)] 1010, Hersteller: Ciba-Ceigy. Mit dem erfindungsgemäßen Entwickler ist es möglich, die unbelichteten Nichtbildstellen eines lichtempfindlichen Materials innerhalb von höchstens etwa 2 min praktisch vollständig zu entfernen, ohne daß dabei merkliche Teile der belichteten Nichtbildstellen mitentfernt werden. Von dem Material der entfernten Nichtbildstellen wird praktisch nichts auf dem Reproduktionsmaterial wiederangelagert.

Die Erfindung wird anhand der folgenden Beispiele erläutert:

Beispiel 1

Eine negativ arbeitende Druckplatte vom Typ ENCO[(R)]N-25, Hersteller: American'Hoechst Corporation, wird mittels aktinischer Strahlung in bekannter Weise bildmäßig belichtet. Die belichtete Platte wird mit einem Entwicklergemisch folgender Zusammensetzung ausgewaschen:

81,35 Gew.-% Wasser,
2,50 Gew.-% Kaliumphosphat,
0,50 Gew.-% Kaliumhydrogenphosphat,
10,10 Gew.-% Abex[(R)] 18-S (35 % Feststoffgehalt),
5,00 Gew.-% α-Hydroxytoluol,
0,05 Gew.-% Dow[(R)] DB-31 (Mittel zur Verhinderung von Schaumbildung).

Die Platte läßt sich sauber entwickeln, ohne daß es zu merklichen Tonerscheinungen an den Bildhintergrundstellen oder zu Wiederanlagerungen von abgelösten Schichtteilen kommt.

Beispiel 2

Beispiel 1 wird wiederholt, mit der Ausnahme, daß der verwendete Entwickler folgende Zusammensetzung hat:

56, 44 Gew.% Wasser,
2,50 Gew.% Propylenglykol
0,50 Gew.% Dikaliumphosphat,
0,50 Gew.% Monokaliumphosphat,
30,00 Gew.% Abex[(R)] 18-S (35% Feststoffgehalt)
10,0 Gew.% α-Hydroxytoluol,
0,05 Gew.% Dow[(R)] DB-31 (zur Verhinderung von Schaumbildung) und
0,01 Gew.% Irganox[(R)] 1010.

Die Ergebnisse entsprechen denen von Beispiel 1.

Beispiel 3

Beispiel 1 wird wiederholt, mit dem Unterschied, daß der verwendete Entwickler folgende Zusammensetzung hat:

82,73 Gew.% Wasser,
2,50 Gew.% Propylethylenglykol
0,62 Gew.% Dinatriumphosphat,
0,32 Gew.% Monoatriumphosphat,
9,20 Gew.% Abex[(R)] 18-S (35% Feststoffgehalt)
4,60 Gew.% α-Hydroxytoluol, und
0,03 Gew.% Dow[(R)] DB-31 (zur Verhinderung von Schaumbildung).

Beispiel 4

Beispiel 1 wird wiederholt, mit dem Unterschied, daß der verwendete Entwickler folgende Zusammensetzung hat:

81,64 Gew.% Wasser,
1,00 Gew.% Polyvinylpyrrolidon,
2,50 Gew.% Propylenglykol
0,50 Gew.% Dikaliumphosphat,
0,50 Gew.% Monokaliumphosphat,
9,20 Gew.% Abex(R) 18-S (35% Feststoffgehalt)
4,60 Gew.% α-Hydroxytoluol,
0,05 Gew.% Dow(R) DB-31 (zur Verhinderung von Schaumbildung) und
0,01 Gew.% Irganox(R) 1010.
Die Ergebnisse entsprechen denen von Beispiel 1.

**Patentansprüche**

1. Organische Lösemittel und Zusätze enthaltender Entwickler für negativ arbeitende Druckplatten mit Aluminium als Trägermaterial, dadurch gekennzeichnet, daß er im wesentlichen aus einem Gemisch aus
a) 4,5 bis 27 Gew.% α-Hydroxytoluol,
b) 0,1 bis 30 Gew.% eines C12-Natriumalkylethersulfats,
c) 0,1 bis 10 Gew.% wenigstens eines Salzes aus der Gruppe der Alkaliphosphate, -nitrate, -chloride, -borate, -acetate, -sulfate, -citrate, -sulfite, -tartrate, -oxalate, -formiate, -propionate, -succinate, -glutamate oder -benzoate und
d) 0,1 bis 10 Gew.% wenigstens einer Verbindung aus der Gruppe Polymethoxyethylenglykol, Polyethylenglykol, Propylenglykol oder Glycerin
besteht, wobei das Gewichtsverhältnis von a) zu b) (bezogen auf den Feststoff) zwischen 0,9:1 und 1,5:1 liegt, der Dampfdruck des Entwicklers 0,15 mm Quecksilbersäule bei 25°C nicht übersteigt und sein Flammpunkt mindestens bei 200°F (93°C) liegt.

2. Entwickler nach Anspruch 1, dadurch gekennzeichnet, daß die Komponente a) mit 4,6 bis 10 Gew.% im Entwickler enthalten ist.

3. Entwickler nach Anspruch 2, dadurch gekennzeichnet, daß die Komponente a) mit 5 bis 7 Gew.% im Entwickler enthalten ist.

4. Entwickler nach Anspruch 1 bis 3, dadurch gekennzeichnet, daß die Komponente b) mit 1 bis 20 Gew.% im Entwickler enthalten ist.

5. Entwickler nach Anspruch 4, dadurch gekennzeichnet, daß die Komponente b) mit 2 bis 10 Gew.% im Entwickler enthalten ist.

6. Entwickler nach einem der Ansprüche 1 bis 5, dadurch gekennzeichnet, daß er zusätzlich noch Antischaummittel und/oder Antioxidantien und/oder Antikorrosionsmittel und/oder filmbildende Mittel enthält.

7. Verfahren zur Herstellung einer Druckplatte mit einer negativ arbeitenden Schicht, die sich auf einem Träger aus Aluminium oder einer Aluminiumlegierung befindet, wobei man die Schicht belichtet und anschließend mit einem organischen Lösemittel und Zusätze enthaltenden Entwickler entwickelt, dadurch gekennzeichnet, daß man innerhalb von 2 Minuten die nicht belichteten Stellen mit einem Entwickler nach den Ansprüchen 1 bis 6 entfernt.

8. Verwendung eines Entwicklers nach einem der Ansprüche 1 bis 7, dadurch gekennzeichnet, daß man Druckplatten mit einer Negativschicht belichtet, die eine lichtempfindliche Diazoniumverbindung der allgemeinen Formel A–N$_2^+$X$^-$ enthält, wobei A ein aromatischer oder heterozyklischer Rest und X das Anion einer Säure bedeuten.

**Claims**

1. Developer, containing organic solvents and additives, for negative-working printing plates with aluminium as the carrier material, characterized in that it is essentially composed of a mixture of
a) 4.5 to 27% by weight of α-hydroxytoluene,
b) 0.1 to 30% by weight of a sodium C$_{12}$-alkylether-sulphate,
c) 0.1 to 10% by weight of at least one salt from the group comprising the alkali metal phosphates, nitrates, chlorides, borates, acetates, sulphates, citrates, sulphites, tartrates, oxalates, formates, propionates, succinates, glutamates or benzoates and
d) 0.1 to 10% by weight of at least one compound from the group comprising polymethoxyethylene glycol, polyethylene glycol, propylene glycol or glycerol,
the a)/b) weight ratio (relative to the solids content) being between 0.9:1 and 1.5:1, the vapour pressure of the developer not exceeding 0.15 mm mercury gauge at 25°C and its flashpoint being at least 200°F (93°C).

2. Developer according to Claim 1, characterized in that 4.6 to 10% by weight of component a) is present in the developer.

3. Developer according to Claim 2, characterized in that 5 to 7% by weight of component a) is present in the developer.

4. Developer according to any of Claims 1 to 3, characterized in that 1 to 20% by weight of component b) is present in the developer.

5. Developer according to Claim 4, characterized in that 2 to 10% by weight of component b) is present in the developer.

6. Development according to any of Claims 1 to 5, characterized in that it additionally also contains antifoams and/or antioxydants and/or corrosion inhibitors and/or film-forming agents.

7. Process for producing a printing plate having a negative-working layer, which is located on a carrier of aluminium or an aluminium alloy, the layer being exposed and then developed by a developer containing an organic solvent and additives, characterized in that the unexposed areas are removed within two minutes by a developer according to Claims 1 to 6.

8. Use of a developer according to any of Claims 1 to 7, characterized in that printing plates having a negative layer, which contains a light-sensitive diazonium compound of the general formula $A-N_2^+X^-$, A being an aromatic or heterocyclic radical and X being the anion of an acid, are exposed.

**Revendications**

1. Révélateur contenant un solvant organique et des additifs, pour plaques d'impression travaillant en négatif et comportant de l'aluminium en tant que matériau de support, caractérisé en ce qu'il consiste essentiellement en un mélange de

a) de 4,5 à 27% en poids d'$\alpha$-hydroxytoluène,

b) de 0,1 à 30 % en poids d'un sulfate d'alkyle en $C_{12}$ et de sodium,

c) de 0,1 à 10% en poids d'au moins un sel choisi parmi des phosphates, nitrates, chlorures, borates, acétates, sulfates, citrates, sulfites tartrates, oxalates, formiates, propionates, succinates, glutamates et benzoates alcalins et

d) de 0,1 à 10% en poids d'au moins um composé choisi parmi le polyméthoxyéthylèneglycol, le polyéthylèneglycol, le propylèneglycol et le glycérol,

le rapport pondéral de a) à b) (en matière sèche) étant compris entre 0,9:1 et 1,5:1, la tension de vapeur du révélateur n'excédant pas 0,15 mm de mercure à 25°C et son point d'inflammation étant d'au moins 200°F (93°C).

2. Révélateur selon la revendication 1, caractérisé en ce que le composant a) est contenu à raison de 4,6 à 10% en poids dans le révélateur.

3. Révélateur selon la revendication 1, caractérisé en ce que le composant a) est contenu à raison de 5 à 7% en poids dans le révélateur.

4. Révélateur selon l'une des revendications 1 à 3, caractérisé en ce que le composant b) est contenu à raison de 1 à 20% en poids dans le révélateur.

5. Révélateur selon la revendication 4, caractérisé en ce que le composant b) est contenu à raison de 2 à 10% en poids dans le révélateur.

6. Révélateur selon l'une des revendications 1 à 5, caractérisé en ce qu'il contient en outre des antimousses et/ou des antioxydants et/ou des agents anticorrosion et/ou des agents feuillogènes.

7. Procédé pour la fabrication d'une plaque d'impression comportant une couche travaillant en négatif, se trouvant sur un support en aluminium ou en un alliage d'aluminium, dans lequel on expose la couche et ensuite on la développe avec un révélateur contenant un solvant organique et des additifs, caractérisé en ce que à l'aide d'un révélateur selon les revendications 1 à 6, on élimine en l'espace de 2 minutes les zones non exposées.

8. Utilisation d'un révélateur selon l'une des revendications 1 à 7, caractérisé en ce que l'on expose des plaques d'impression comportant un couche négative qui contient un composé photosensible de type diazonium de formule générale $AN_2^+X^-$, A représentant un radical aromatique ou hétérocyclique et X représentant l'anion d'un acide.